# EUROPEAN PATENT APPLICATION

(11) **EP 4 186 755 A1**
(43) Date of publication of application: **31.05.2023**
(21) Application number: 22205199.7
(22) Date of filing: 03.11.2022
(51) Int. Cl.: B60R 16/03, B60R 16/023

(54) **ELECTRICAL BOX**

(30) Priority: 24.11.2021 CN 202122903211 U
(71) Applicant: Beijing Tusen Zhitu Technology Co., Ltd., Beijing 100016 (CN)
(72) Inventor: HE, Xiaokang, Beijing, 100016 (CN); WANG, Chi, Beijing, 100016 (CN); JI, Pingyuan, Beijing, 100016 (CN)
(74) Representative: Murgitroyd & Company

(57) **Abstract**

The present disclosure provides an electrical box, wherein the electrical box comprises: a first circuit comprising a first power input interface at one end of the first circuit and a first power output interface at another end of the first circuit; a second circuit comprising a second power input interface at one end of the second circuit and a second power output interface at another end of the second circuit; and a third circuit electrically connected to the first and second circuits and comprising a third power output interface at one end of the third circuit.

## Description

### TECHNICAL FIELD

The present disclosure relates to an electrical box, and in particular to an electrical box for a vehicle.

### BACKGROUND

A vehicle may comprise various devices that require power (i.e., electrical devices) for various applications. For example, various sensors may be mounted on the vehicle for safety purposes, driving assistance, or facilitating autonomous driving, and the sensors mounted on the vehicle may acquire sensor data of various aspects around the vehicle. The vehicle may also be equipped with a computing apparatus for processing the sensor data, and the sensor data processing result may be used to safely operate the vehicle. In order to acquire and process the sensor data, the sensors, computing apparatus and other devices in the vehicle require power. For the safety of the vehicle, it is necessary to consider the problem of power supply to the electrical devices when the power source fails.

### SUMMARY

The present disclosure provides an electrical box, wherein the electrical box may be connected between a power source and an electrical device and supports redundant power supply to the electrical device.

In one aspect, the present disclosure provides an electrical box comprising: a first circuit comprising a first power input interface at one end of the first circuit and a first power output interface at another end of the first circuit; a second circuit comprising a second power input interface at one end of the second circuit and a second power output interface at another end of the second circuit; and a third circuit electrically connected to the first and second circuits and comprising a third power output interface.

In another aspect, the present disclosure provides an electrical box comprising: a first circuit configured to provide power from a first power source to a first group of electrical devices; a second circuit configured to provide power from a second power source to a second group of electrical devices; and a third circuit configured to provide the power from the first power source and the power from the second power source to a third group of electrical devices.

The electrical box provided by the present disclosure comprises a plurality of circuits that can provide power from a plurality of power sources to an electrical device to support redundant power supply to the electrical device. When one power source fails, the electrical box can provide power from additional power sources to the electrical device, so as to ensure that the apparatus comprising the electrical device continues to operate safely (for example, the vehicle comprising the electrical device continues to travel safely or has sufficient power to travel to a safe location).

### BRIEF DESCRIPTION OF THE DRAWINGS

The accompanying drawings illustrate the exemplary embodiments and constitute a part of the specification, and, together with the text description of the specification, are provided to illustrate the exemplary implementations of the embodiments. It is obvious that the accompanying drawings described below are only some embodiments of the invention. For those of ordinary skilled in the art, other drawings can be derived from the accompanying drawings without creative effort. Throughout the accompanying drawings, identical reference numerals designate similar, but not necessarily identical, elements.
FIG. 1 is a schematic structural diagram of an electrical box according to an exemplary embodiment;
FIG. 2 is a schematic diagram of supplying power to an electrical device by a power source through an electrical box according to an exemplary embodiment;
FIG. 3 is a schematic structural diagram of an electrical box according to another exemplary embodiment;
FIG. 4A is a schematic diagram of the mounting process of the cover plate of an electrical box according to an exemplary embodiment;
FIG. 4B is an enlarged view of the portion shown in block A in FIG. 4A; and
FIG. 5 is a top view of an electrical box with the cover plate mounted according to an exemplary embodiment.

### DETAILED DESCRIPTION

In order to make the purposes, technical schemes and advantages of the invention more apparent, the invention will be described in further detail with reference to the accompanying drawings. It is obvious that the described embodiments are only part of the embodiments of the invention rather than all of the embodiments. Based on the embodiments in the invention, all other embodiments obtained by those of ordinary skill in the art without creative work shall fall within the protection scope of the invention.

In the present disclosure, unless otherwise specified, the term "plurality" means two or more. In the present disclosure, unless otherwise specified, the terms "first", "second", and the like are used for distinguishing between similar objects, and are not intended to limit position relationships, timing relationships, or importance relationships thereof. It is to be understood that the terms used in this manner are interchangeable under appropriate circumstances so that the embodiments of the invention described herein can be implemented in other manners in addition to those illustrated or described herein.

Moreover, the terms "comprise" and "have" and any variations thereof are intended to cover non-exclusive inclusion. For example, a process, method, system, product or device comprising a series of steps or units is not necessarily limited to the explicitly listed steps or units, but may comprise other steps or units that are not explicitly listed or are inherent in the process, method, system, product or device.

With the development of the vehicle electronic and electrical system and autonomous driving, the safety level requirement for the vehicle electronic and electrical system is higher and higher. Therefore, part of the electronic and electric system begin to be subjected to redundancy design, and meanwhile there is also a need for redundant power supply. After considering factors such as cost and weight, the inventor also thinks that it is not necessary to perform redundant design on all electrical devices in the whole system, and only some electrical devices (these electrical devices are also called primary electrical devices, and the redundancy of the primary electrical devices is also called secondary electrical devices) may be subjected to redundant design, while other electrical devices are not subjected to redundant design (these electrical devices are also called shared electrical devices). In this way, the electrical devices may be classified into primary electrical devices, secondary electrical devices (i.e., the redundancy of the primary electrical devices) and shared electrical devices, and the power supply thereto is designed according to the classification of the electrical devices. The primary electrical devices may be powered by the primary power source, the secondary electrical devices may be powered by the secondary power source, and the shared electrical devices may be powered by both the primary power source and the secondary power source. Based on this concept, the present disclosure provides an electrical box that may be mounted on a vehicle (e.g., an autonomous vehicle) to support redundant power supply.

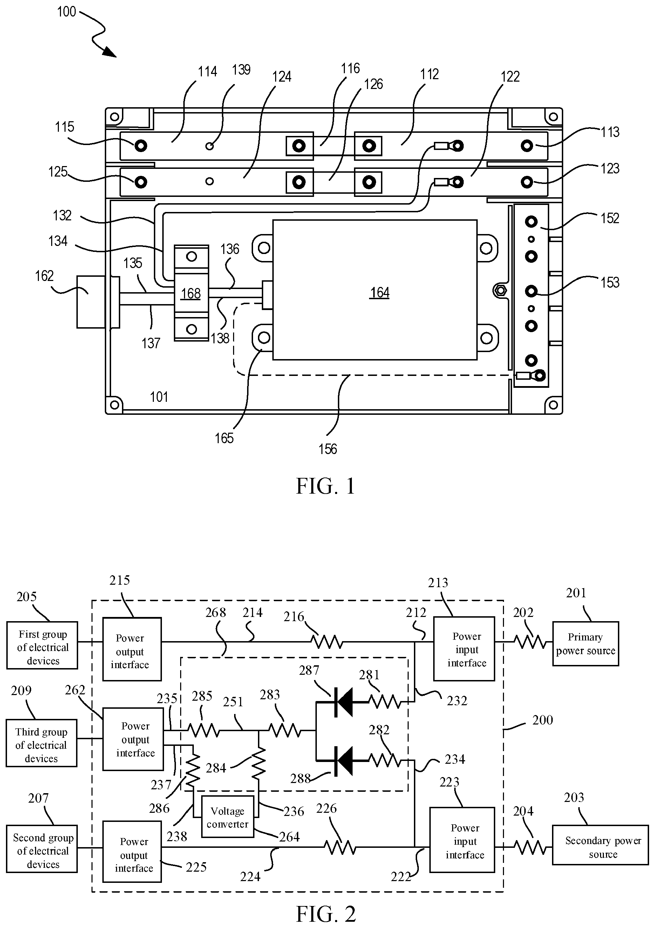

FIG. 1 is a schematic structural diagram of an electrical box according to an exemplary embodiment. As shown in FIG. 1, the electrical box 100 comprises a base plate 101. Various elements may be mounted or fixed on a surface of the base plate 101. The base plate has mounting holes at its periphery. For example, in FIG. 1, the mounting holes of the base plate are positioned at four corners. Through these mounting holes, the base plate may be fixed on the vehicle, thereby the electrical box may be fixed on the vehicle. The base plate 101 may have a shape such as a rectangle, a square, a triangle, a pentagon, a hexagon, a circle or an ellipse, or the shape of the base plate may be designed according to the mounting position of the electrical box on the vehicle.

As shown in FIG. 1, one or more electric conductors, such as electric conductors 112, 114, 122, 124 and 152, are mounted on a surface of the base plate 101. To reduce space occupation for facilitating the miniaturization of the electrical box, one or more or all of the electric conductors may be composed of metal strips and not coated with an insulating material. The cross-section of the metal strip may be rectangular, and the width of the metal strip may be at least 5 times, or at least 10 times, or at least 20 times the thickness. Because the metal strip is not coated with an insulating material, the surface of the metal strip may be subjected to anti-oxidation treatment in order to prevent the metal strip from being oxidized. For example, the metal strip may be a copper strip, and the surface of the copper strip may be tin-plated.

The electric conductors may be electrically connected using a protection element, for example, electric conductors 112 and 114 are electrically connected to each other using a protection element 116, electric conductors 122 and 124 are electrically connected to each other using a protection element 126, and the protection elements may prevent overcurrent. For example, the protection element 116 may electrically disconnect the electric conductors 112 and 114 when the current flowing through the electric conductors 112 and 114 (or the current flowing through the protection element 116) exceeds a first predetermined threshold. Similarly, the protection element 126 may electrically disconnect the electric conductors 122 and 124 when the current flowing through the electric conductors 122 and 124 (or the current flowing through the protection element 126) exceeds a second predetermined threshold. The first predetermined threshold and the second predetermined threshold may be the same or different (for example, the first predetermined threshold is greater than the second predetermined threshold, such as the first predetermined threshold is 125 amps and the second predetermined threshold is 60 amps).

One example of the protection elements is a fuse (e.g., a slow blow fuse). The fuse will blow itself to cut off the current when the current rises abnormally above a predetermined threshold. Another example of the protection elements is a switch with a current detector that opens when the current detector detects that the current rises abnormally above the predetermined threshold.

As shown in FIG. 1, the electric conductor 112 has an opening at one end and the end forms a power input interface 113. The other end of the electric conductor 112 is electrically connected to the protection element 116. The power source may be electrically connected to the power input interface 113 via a wire, and the wire may be fixed relative to the electric conductor 112 via the opening in the electric conductor 112. The electric conductor 114 has an opening at one end and the end forms a power output interface 115. The other end of the electric conductor 114 is electrically connected to the protection element 116. The electrical devices may be electrically connected to the power output interface 115 via a wire, and the wire may be fixed relative to the electric conductor 114 via the opening in the electric conductor 114. The electric conductor 122 has an opening at one end and the end forms a power input interface 123. The other end of the electric conductor 122 is electrically connected to the protection element 126. The power source may be electrically connected to the power input interface 123 via a wire, and the wire may be fixed relative to the electric conductor 122 via the opening in the electric conductor 122. The electric conductor 124 has an opening at one end and the end forms a power output interface 125. The other end of the electric conductor 124 is electrically connected to the protection element 126. The electrical devices may be electrically connected to the power output interface 125 via a wire, and the wire may be fixed relative to the electric conductor 124 via the opening in the electric conductor 124. The electric conductor 152 is a ground line, forms a ground interface and has a plurality of openings 153. The ground line in the power source may be electrically connected to the electric conductor 152 via a wire, and the wire may be fixed relative to the electric conductor 152 via the openings in electric conductor 152. The electric conductor 152 may form a ground circuit and in an example it may comprises a copper strip having a surface that is tin-plated.

In some embodiments, the openings in the electric conductors (e.g., the electric conductor 112, the electric conductor 114, the electric conductor 122, the electric conductor 124 and the electric conductor 152) shown in FIG. 1 may be round holes. In some embodiments, the electric conductors (e.g., the electric conductor 112, the electric conductor 114, the electric conductor 122, the electric conductor 124 and the electric conductor 152) shown in FIG. 1 may not comprise openings, instead recesses may be formed on both sides of the electric conductors at locations corresponding to the openings, or protrusions (e.g., cylindrical protrusions) may be formed on the surface of the electric conductors. By comprising an opening, a recess or a protrusion in the power input interface or the power output interface of the electric conductor, the electrical connection of the power input interface or the power output interface to the power source or the electrical device may be enhanced, and the corresponding wires for the electrical connection may be fixed.

In some embodiments, the electric conductor 112, the electric conductor 114, the electric conductor 122, the electric conductor 124 and the electric conductor 152 have mounting holes (e.g., mounting hole 139) through which the electric conductors may be fixed on the base plate 101.

As shown in FIG. 1, the electrical box 100 further comprises electric conductors 132 and 134 and a power output interface 162. One end of each of the electric conductors 132 and 134 is electrically connected to the electric conductors 112 and 122, respectively, and the other ends thereof may be electrically connected to the power output interface 162 through, for example, a protection element, so that the electric conductors 112 and 122 are electrically connected to the power output interface 162. Although the electric conductors 132 and 134 are electrically connected to the electric conductors 112 and 122 in FIG. 1, respectively, the electric conductors 132 and 134 may also be electrically connected to the electric conductors 114 and 124, respectively. The electric conductors 132 and/or 134 may be wires (e.g., copper wires) that have a surface coated with an insulating material. The wires may be round or oval in cross-section. The power output interface 162 may be various connectors (e.g., a vehicle-scale connector) for electrically connecting to electrical devices.

As described above, the power input interface 113 and the power input interface 123 may be electrically connected to a power source. The power output interface 115, the power output interface 125 and the power output interface 162 may be electrically connected to electrical devices. Examples of the power source comprise a generator (e.g., the generator in a vehicle) and a battery. Examples of the electrical devices comprise a sensor system, a computing apparatus and/or a control apparatus.

In some embodiments, the electrical box 100 further comprises a safety box 168, wherein the safety box may have one or more protection elements therein for preventing overcurrent. The safety box is connected between the electric conductors 132 and 134 and the power output interface 162, and is electrically connected to the power output interface 162 through the electric conductors 135 and 137. The electric conductors 135 and 137 may be wires (e.g., copper wires) that may be round or oval in cross-section and that have a surface coated with an insulating material. The safety box may further have one or more anti-reverse elements to prevent reverse current. The safety box 168 has, for example, mounting holes on both sides, and the safety box 168 may be fixed on the base plate 101 through the mounting holes.

In some embodiments, the electrical box 100 further comprises a voltage converter 164 for converting, i.e., stepping up or stepping down, the voltage of the power source. The voltage converter 164 has one or more mounting portions 165, wherein the mounting portions have mounting holes therein, and the voltage converter 164 is fixed on the base plate 101 through the mounting holes. The voltage converter 164 has an input electrically connected to the electric conductor 136 and an output electrically connected to the electric conductor 138. The voltage converter 164 may be electrically connected to the safety box 168 through electric conductors 136 and 138, such that power from the power source is provided to the voltage converter 164 via the electric conductors 132 and 134 and the safety box 168, and power converted (i.e., stepped-up or stepped-down) by the voltage converter 164 is provided to the power output interface 162 via the safety box 168. The electric conductors 136 and 138 may be wires (e.g., copper wires) that may be round or oval in cross-section and that have a surface coated with an insulating material.

The electric conductor 156 is also shown in the dashed line in FIG. 1 for electrically connecting the voltage converter 164 to the electric conductor 152 as the ground line. The safety box 168 and the power output interface 162 may also be electrically connected to the electric conductor 152 by electric conductors (not shown). The electric conductors connected to the electric conductor 152 may be wires (e.g., copper wires) that may be round or oval in cross-section and that have a surface coated with an insulating material.

In some embodiments, the electrical devices may be divided into a plurality of groups, such as a first group of electrical devices, a second group of electrical devices and a third group of electrical devices. The power source may comprise a plurality of power sources (e.g., two). The power input interfaces are electrically connected to different power sources. The power output interfaces are electrically connected to different groups of electrical devices.

In some embodiments, one group of electrical devices are used as the redundancy of the other group of electrical devices, for example, the second group of electrical devices are used as the redundancy of the first group of electrical devices, and the two power sources are redundant to each other. In this case, the first group of electrical devices are also called primary electrical devices, the second group of electrical devices are also called secondary electrical devices, and the two power sources that are redundant to each other are called a primary power source and a secondary power source, respectively. The primary electrical devices are powered by the primary power source, and the secondary electrical devices are powered by the secondary power source. When the primary power source or the primary electrical devices fail, the primary electrical devices stop operating, and the secondary electrical devices are powered by the secondary power source to replace the primary electrical devices to operate. The third group of electrical devices may be powered jointly by the primary power source and the secondary power source, and in this sense, the third group of electrical devices are also called shared electrical devices.

As shown in FIG. 1, the primary power source may be electrically connected to the electric conductor 112 through the power input interface 113, the electric conductor 112 may be electrically connected to the electric conductor 114 through the protection element 116, and the electric conductor 114 may be electrically connected to the primary electrical devices through the power output interface 115. The secondary power source may be electrically connected to the electric conductor 122 through the power input interface 123, the electric conductor 122 may be electrically connected to the electric conductor 124 through the protection element 126, and the electric conductor 124 may be electrically connected to the secondary electrical devices through the power output interface 125. The primary power source and the secondary power source are electrically connected to the electric conductor 112 and the electric conductor 122 through the power input interface 113 and the power input interface 123, respectively, then electrically connected to the power output interface 162 through the electric conductors 132 and 134 and the safety box 168, and electrically connected to the shared electrical devices through the power output interface 162.

When the primary electrical devices fail, causing the current in the electric conductor 112 or the electric conductor 114 (or the current in the protection element 116) to exceed a predetermined threshold, the protection element 116 will electrically disconnect the electric conductor 112 and the electric conductor 114, so that the primary power source no longer provides power to the primary electrical devices, which causes the primary electrical devices to stop operating. Similarly, when the primary power source fails, the primary power source no longer provides power to the primary electrical devices, which causes the primary electrical devices to stop working. As described above, when the primary electrical devices stop operating, the secondary electrical devices may be configured to replace the primary electrical devices to operate.

When the secondary electrical devices fail, causing the current in the electric conductor 122 or the electric conductor 124 (or the current in the protection element 126) to exceed a predetermined threshold, the protection element 126 will electrically disconnect the electric conductor 122 and the electric conductor 124, so that the secondary power source no longer provides power to the secondary electrical devices, which causes the secondary electrical devices to stop operating. Similarly, when the secondary power source fails, the secondary power source no longer provides power to the secondary electrical devices, which causes the secondary electrical devices to stop working. According to an embodiment of the present application, after the secondary electrical devices stop operating, the shared electrical devices may also continue to operate, for example, the vehicle may be stopped in an emergency. Moreover, since the shared electrical devices are powered jointly by the primary power source and the secondary power source, when any one of the primary power source and the secondary power source fails, the other may continue to provide power to the shared electrical devices.

In some embodiments, the electrical box 100 further comprises relay(s), one or more of the power output interfaces of the electrical box 100 may be electrically connected to the relays, and the electrical devices may be electrically connected to the power output interfaces through the relays, so that the power supply to the electrical devices may be controlled by controlling the opening and closing of the relays when needed.

In some embodiments, at one or more edges of the base plate 101 of the electrical box 100, it may form side plates of the electrical box 100 on which a cover plate (not shown in FIG. 1) may be mounted. These side plates extend upward from a surface of the base plate 101 to form a space for accommodating various elements. Some elements, such as the power output interface 162, may be fixed on the side plates. The base plate, the side plates and/or the cover plate may be made of any insulating material, and in some embodiments, the base plate, the side plates and/or the cover plate are made of polyamide and fiberglass, for example, made of polyamide 66 plus 30% fiberglass. The base plate, the side plates and/or the cover plate that consist of polyamide and glassfiber have good temperature resistance and are suitable for vehicle-mounted applications.

FIG. 2 illustrates a circuit diagram reflecting a use environment of the electrical box according to an exemplary embodiment of the present application. As shown in FIG. 2, the electrical box 200 comprises at least three circuits. A first circuit comprises a power input interface 213 at one end thereof and a power output interface 215 at the other end thereof, and the first circuit is configured to provide power from a first power source (i.e., a primary power source 201) to a first group of electrical devices 205. A second circuit comprises a power input interface 223 at one end thereof and a power output interface 225 at the other end thereof, and the second circuit is configured to provide power from a second power source (i.e., a secondary power source 203) to a second group of electrical devices 207. A third circuit is electrically connected to the first circuit and the second circuit, comprises a power output interface 262, and is configured to provide the power from the first power source (i.e., the primary power source 201) and the power from the second power source (i.e., the secondary power source 203) to a third group of electrical devices 209. The electrical box 200 may be, for example, the electrical box 100 in FIG. 1. It should be noted that, for simplicity, the ground line of the electrical box and the corresponding wire connected to the ground line are not shown in FIG. 2.

As shown in FIG. 2, the first circuit comprises an electric conductor 212, a protection element 216 and an electric conductor 214. The primary power source 201 is electrically connected to the power input interface 213 at one end of the electric conductor 212 through a protection element 202, the electric conductor 212 is electrically connected to the electric conductor 214 through a protection element 216, and the power output interface 215 at one end of the electric conductor 214 is electrically connected to the first group of electrical devices 205. The first group of electrical devices may be the primary electrical devices mentioned above. The protection element 202 may be a fuse or a switch with a current detector. The power input interface 213, the electric conductor 212, the protection element 216, the electric conductor 214 and the power output interface 215 may be the power input interface 113, the electric conductor 112, the protection element 116, the electric conductor 114 and the power output interface 115 described above with reference to FIG. 1.

The second circuit comprises an electric conductor 222, a protection element 226 and an electric conductor 224. The secondary power source 203 is electrically connected to the power input interface 223 at one end of the electric conductor 222 through a protection element 204, the electric conductor 222 is electrically connected to the electric conductor 224 through a protection element 226, and the power output interface 225 at one end of the electric conductor 224 is electrically connected to the second group of electrical devices 207. The second group of electrical devices may be the secondary electrical devices mentioned above. The protection element 204 may be a fuse or a switch with a current detector. The power input interface 223, the electric conductor 222, the protection element 226, the electric conductor 224 and the power output interface 225 may be the power input interface 123, the electric conductor 122, the protection element 126, the electric conductor 124 and the power output interface 125 described above with reference to FIG. 1.

The third circuit comprises electric conductors 232 and 234, a safety box 268, electric conductors 235 and 237, and a power output interface 262. The primary power source 201 and the secondary power source 203 are electrically connected to the electric conductors 232 and 234 through the protection elements 202 and 204 and the electric conductors 212 and 222, respectively, then electrically connected to the power output interface 262 through the electric conductors 232 and 234, the safety box 268 and the electric conductors 235 and 237, and electrically connected to the third group of electrical devices 209 through the power output interface 262. The third group of electrical devices may be the shared electrical devices mentioned above. The safety box 268 may be the safety box 168 described above with reference to FIG. 1, and the electric conductors 232, 234, 235 and 237 may be the electric conductors 132, 134, 135 and 137 described above with reference to FIG. 1.

As shown in FIG. 2, the safety box 268 comprises protection elements 281 and 282, one end of the protection element 281 is electrically connected to the electric conductor 232, and the other end thereof is electrically connected to an anti-reverse element 287. One end of the protection element 282 is electrically connected to the electric conductor 234, and the other end thereof is electrically connected to an anti-reverse element 288. The anti-reverse element allows current to flow in one direction (e.g., a direction of the power sources toward the electrical devices) and prevents current from flowing in the opposite direction (e.g., a direction toward the power sources). One example of the anti-reverse element is a diode (i.e., an anti-reverse diode). Due to the presence of the anti-reverse element 287 and the anti-reverse element 288, a current may be prevented from flowing from the primary power source 201 to the secondary power source 203, and the current is prevented from flowing from the secondary power source 203 to the primary power source 201.

The anti-reverse element 287 and the anti-reverse element 288 are electrically connected to the power output interface 262 through a protection element 283, an electric conductor 251, a protection element 285 and the electric conductor 235. The protection elements 281, 282, 283 and 285 may be fuses or switches with current detectors. It can be seen from FIG. 2, the third group of electrical devices (i.e., the shared electrical devices) are powered jointly by the primary power source 201 and the secondary power source 203. Therefore, when one of the primary power source 201 and secondary power source 203 fails, the other may continue to provide power to the third group of electrical devices.

As shown in FIG. 2, the third circuit may further comprise a voltage converter 264, one end of the voltage converter 264 is electrically connected to the electric conductor 251 through the electric conductor 236 and the protection element 284, the other end thereof is electrically connected to the electric conductor 237 through the electric conductor 238 and the protection element 286, and the electric conductor 237 is electrically connected to the power output interface 262. Thus, at least two voltages with different magnitudes may be provided on the power output interface 262, one voltage has the same magnitude as that of one power source, and the other voltage has a larger or smaller magnitude than that of the power source. In some embodiments, the primary power source 201 and the secondary power source 203 have the same voltage. For example, the voltage of the primary power source and the secondary power source is 24 volts, and the voltage converter 264 may reduce the voltage of 24 volts to 12 volts, so that two different voltages of 24 volts and 12 volts may be provided on the power output interface 262.

By providing different magnitudes of voltages on the power output interface 262, power consumption requirements of the electrical devices with different magnitudes of voltages may be satisfied. The voltage converter 264 may be the voltage converter 164 described above with reference to FIG. 1. The electric conductors 236 and 238 may be the electric conductors 136 and 138 described above with reference to FIG. 1.

Each protection element in the safety box 268 may be a fuse (e.g., a slow blow fuse) or a switch with a current detector. The protection element may electrically disconnect the corresponding electric conductors when the current flowing through the corresponding electric conductors (or the current flowing through the protection element) exceeds a predetermined threshold. The predetermined threshold may be flexibly set as desired, for example, the predetermined threshold corresponding to the protection element 283 may be greater than the predetermined thresholds corresponding to the protection elements 281 and 282. The predetermined threshold corresponding to the protection element 283 may also be greater than the predetermined thresholds corresponding to the protection elements 284, 285 and 286. The predetermined thresholds corresponding to the protection element 281 and the protection element 282 may be the same.

In some embodiments, the electrical box 200 may also comprise more or fewer circuits. For example, the electrical box 200 may further comprise (one or more) additional circuits and/or (one or more) further additional circuits, wherein an additional circuit may have a structure that is the same as or similar to that of the first circuit, a power input interface at one end of the additional circuit is electrically connected to the primary power supply 201 through the protection element 202, and a power output interface at the other end of the additional circuit is electrically connected to the first group of electrical devices. In a case where the additional circuit is comprised, the power output interfaces of the first circuit and the additional circuit may be electrically connected to the same or different electrical devices of the first group of electrical devices. A further additional circuit may have a structure that is the same as or similar to that of the second circuit, a power input interface at one end of the further additional circuit is electrically connected to the secondary power source 203 through the protection element 204, and a power output interface at the other end of the further additional circuit is electrically connected to the second group of electrical devices. In a case where the further additional circuit is comprised, the power output interfaces of the second circuit and the further additional circuit may be electrically connected to the same or different electrical devices of the second group of electrical devices.

In FIG. 2, the protection element 283 is electrically connected to the power output interface 262 through a first sub-circuit comprising the electric conductor 251, the protection element 285 and the electric conductor 235; and those of skilled in the art will appreciate that the electrical box 200 may further comprise more sub-circuits that are the same as or similar to the first sub-circuit, and are electrically connected between the protection element 283 and the power output interface 262. Moreover, in FIG. 2, the voltage converter 264 is electrically connected to the power output interface 262 through a second sub-circuit comprising the electric conductor 238, the protection element 286 and the electric conductor 237; and those of skilled in the art will appreciate that the electrical box 200 may further comprise more sub-circuits that are the same as or similar to the second sub-circuit, and are electrically connected between the voltage converter 264 and the power output interface 262.

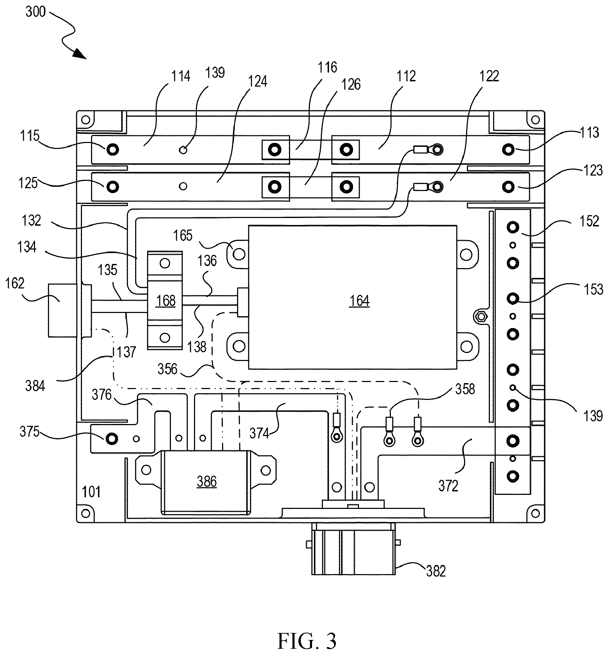

FIG. 3 is a schematic structural diagram of an electrical box according to another exemplary embodiment. The following description focuses on the differences between an electrical box 300 in FIG. 3 and the electrical box 100 in FIG. 1, and the same or similar parts are not repeated. It should be noted that the same reference numerals are used for the parts of the electrical box 300 shown in FIG. 3 that are the same as or similar to that of the electrical box 100 in FIG. 1.

As shown in FIG. 3, the electrical box 300 further comprises electric conductors 372, 374 and 376 with respect to the electrical box 100. One end of the electric conductor 372 is electrically connected to a power input interface 382 and the other end thereof is electrically connected to the electric conductor 152 (i.e., the ground line), one end of the electric conductor 374 is electrically connected to the power input interface 382 and the other end thereof is electrically connected to a relay 386, and the electric conductor 376 has an opening at one end and the end forms a power output interface 375. The other end of the electric conductor 376 is electrically connected to the relay 386. The power input interface 382, the electric conductors 372, 374 and 376, and the relay 386 may form a fourth circuit. One or more or all of the electric conductors 372, 374 and 376 may be composed of a metal strip and not coated with an insulating material. The cross-section of the metal strip may be rectangular, and the width of the metal strip may be at least 5 times, or at least 10 times, or at least 20 times the thickness. Because the metal strip is not coated with an insulating material, the surface of the metal strip may be subjected to anti-oxidation treatment in order to prevent the metal strip from being oxidized. For example, the metal strip may be a copper strip, and the surface of the copper strip may be tin-plated. The relay 386 has, for example, mounting holes on both sides and is fixed on the base plate 101 through the mounting holes. In some embodiments, the electric conductors 372, 374 and 376 have mounting holes through which the electric conductors are fixed on the base plate 101.

In some embodiments, the opening in the electric conductor 376 shown in FIG. 3 may be a round hole. In some embodiments, the electric conductor 376 may not comprise openings, instead recesses may be formed on both sides of the electric conductor 376 at locations corresponding to the openings, or protrusions (e.g., cylindrical protrusions) may be formed on the surface of the electric conductor 376. The electric conductor 356 in FIG. 3 (represented in the dashed line) differs from the electric conductor 156 in FIG. 1 in that the electric conductor 356 is not directly electrically connected to the electric conductor 152 (i.e., the ground line), but is electrically connected to the electric conductor 152 (i.e., the ground line) through the electric conductor 372. Moreover, the electric conductor 356 in FIG. 3 is further electrically connected to the relay 386. Also, the electrical box 300 in FIG. 3 further comprises the electric conductor 358 (represented in the dashed line) configured to electrically connect the power input interface 382 to the electric conductor 372. The electric conductor 358 may serve as a ground line corresponding to a signal line connected to the power input interface 382. The electric conductors 356 and 358 may be wires (e.g., copper wires) that may be round or oval in cross-section and that have a surface coated with an insulating material.

In some embodiments, the primary power source and the secondary power source described above may be vehicle-mounted power sources (e.g., batteries) that may be charged by a generator of the vehicle. When the vehicle is located in a garage or parking lot, the vehicle may be powered by a power source (also called shore power) in the garage or parking lot in order to save energy on the vehicle. The power input interface 382 may be various connectors (e.g., a vehicle-scale connector), and the shore power may be electrically connected to the power input interface 382 to provide power to the electrical devices (e.g., the first group of electrical devices 205, the second group of electrical devices 207 and/or the third group of electrical devices 209 shown in FIG. 2) on the vehicle through the electric conductor 374, the relay 386 and the electric conductor 376 (the electrical devices may be electrically connected to the power output interface 375). The ground line of the shore power may be electrically connected to the electric conductor 372 through the power input interface 382.

As shown in FIG. 3, the electrical box 300 further comprises one or more signal lines 384 (represented in the dotted lines), one end of the signal line is electrically connected to the power output interface 162, and the other end thereof is electrically connected to the relay 386, the electric conductor 374 and the power input interface 382. For example, a control apparatus (or controller) in the vehicle may be connected to the power output interface 162, the control apparatus may detect the contact of the shore power with the power input interface 382 through the signal line, and the control apparatus may detect voltage or current on the electric conductor 374 through the signal line, and controls the relay 386 to open and close through the signal line according to the contact detection result and/or the voltage (or current) detection result. For example, when the control apparatus detects that the shore power is contacted with the power input interface 382 through the signal line, the control apparatus controls the relay to close so that the shore power may provide power to the electrical devices on the vehicle, and when the control apparatus detects that the voltage (or current) on the electric conductor 374 is excessive through the signal line, the control apparatus controls the relay to open. Therefore, the damage to the electrical devices resulting from the excessive voltage or current of the shore power may be avoided.

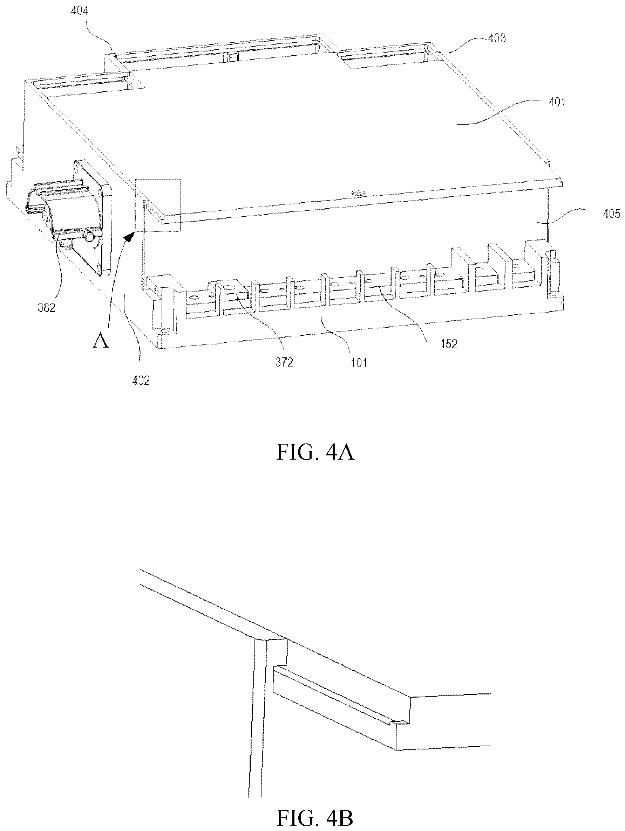

FIG. 4A is a schematic diagram of the mounting process of the cover plate of an electrical box according to an exemplary embodiment, wherein the electrical box may be, for example, the electrical box 300 shown in FIG. 3. FIG. 4B is an enlarged view of the portion shown in block A in FIG. 4A. As shown in FIG. 4A, side plates of the electrical box, for example, side plates 402, 403, 404 and 405, are positioned on edges of the base plate 101 and extend upward from a surface of the base plate 101 to form a space for accommodating various elements. Some elements may be fixed on the side plates, for example, the power input interface 382 is fixed on the side plate 402.

The cover plate and the side plates of the electrical box may be fixed by adopting a sliding groove and a bolt, which is convenient for disassembly. As shown in FIGs. 4A and 4B, the side plates 402, 403 and 404 have sliding grooves, the cover plate 401 has protruding sliding blocks corresponding to the sliding grooves, and the sliding blocks and the sliding grooves are in clearance fit when the sliding blocks slide in the sliding grooves, so as to mainly avoid excessive resistance of the cover plate and the side plates in the assembling process caused by processing errors and product deformation during processing. When the sliding of the sliding blocks in the sliding grooves is finished, the sliding blocks and the sliding grooves are in interference fit, so that after the cover plate is assembled, a certain retaining force is provided, and meanwhile, the assembling clearance between the cover plate and the side plates is reduced.

The base plate 101, the side plates 402, 403, 404 and 405 and/or the cover plate 401 may be made of polyamide and fiberglass, for example, made of polyamide 66 plus 30% fiberglass.

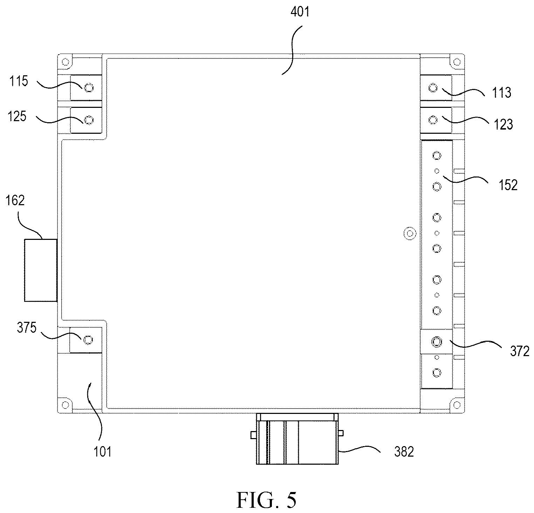

FIG. 5 is a top view of the cover plate in FIG. 4A after mounting. As shown in FIG. 5, when the cover plate is mounted, a portion of the power output interfaces 115, 125 and 375, the power input interfaces 113 and 123, the electric conductor 152 (i.e., the ground line) and the electric conductor 372 is exposed outside the electrical box, so as to facilitate the electrical connection of the power source, the electrical devices and the like.

Although exemplary embodiments or examples of the present disclosure have been described with reference to the accompanying drawings, it should be understood that the above exemplary discussion is not intended to be exhaustive or to limit the invention to the precise forms disclosed. Many modifications and variations are possible in view of the above teachings. Therefore, the disclosed subject matter should not be limited to any single embodiment or example described herein, but rather should be construed in breadth and scope in accordance with the appended claims.

## Claims

1. An electrical box, comprising:
a first circuit comprising a first power input interface at one end of the first circuit and a first power output interface at another end of the first circuit;
a second circuit comprising a second power input interface at one end of the second circuit and a second power output interface at another end of the second circuit; and
a third circuit electrically connected to the first and second circuits and comprising a third power output interface.

2. The electrical box according to claim 1, wherein at least one of the first circuit and the second circuit comprises at least two electric conductors and a protection element electrically connected to the at least two electric conductors.

3. The electrical box according to claim 2, wherein the electric conductors each comprise a copper strip having a surface that is tin-plated.

4. The electrical box according to claim 1,
wherein the first circuit comprises at least two electric conductors, one end of one of the electric conductors forming the first power input interface and one end of another one of the electric conductors forming the first power output interface, or
wherein the second circuit comprises at least two electric conductors, one end of one of the electric conductors forming the second power input interface and one end of another one of the electric conductors forming the second power output interface.

5. The electrical box according to any of claims 1-4, wherein:
the third circuit at least comprises a first electric conductor, a second electric conductor and a safety box,
one end of the first electric conductor is electrically connected to the first circuit, and another end of the first electric conductor is electrically connected to the safety box, and
one end of the second electric conductor is electrically connected to the second circuit, and another end of the second electric conductor is electrically connected to the safety box.

6. The electrical box according to claim 5, wherein the safety box comprises:
a first protection element electrically connected to the other end of the first electric conductor; and
a second protection element electrically connected to the other end of the second electric conductor.

7. The electrical box according to claim 5, wherein the safety box comprises:
a first anti-reverse element electrically connected to the other end of the first electric conductor; and
a second anti-reverse element electrically connected to the other end of the second electric conductor.

8. The electrical box according to claim 7, wherein the safety box further comprises:
a protection element electrically connected to each of the first anti-reverse element and the second anti-reverse element.

9. The electrical box according to claim 5, wherein:
the third circuit further comprises a voltage converter having an input and an output both electrically connected to the safety box and configured to provide a different voltage at the output than that at the input.

10. The electrical box according to any of claims 1-9, further comprising:
a fourth circuit comprising a third power input interface at one end of the fourth circuit and a fourth power output interface at another end of the fourth circuit,
wherein the fourth circuit further comprises at least two electric conductors and a switching element electrically connected to the at least two electric conductors.

11. The electrical box according to claim 10, further comprising at least one signal line configured to provide data communication between the fourth power output interface and at least one of the third power input interface, the electric conductors of the fourth circuit and the switching element.

12. An electrical box, comprising:
a first circuit configured to provide power from a first power source to a first group of electrical devices;
a second circuit configured to provide power from a second power source to a second group of electrical devices; and
a third circuit configured to provide the power from the first power source and the power from the second power source to a third group of electrical devices.

13. The electrical box according to claim 12, further comprising an anti-reverse element configured to prevent current flowing from one of the first power source and the second power source to the other.

14. The electrical box according to claim 12 or 13, wherein the first circuit, the second circuit and the third circuit each comprise a protection element configured to prevent current flowing through the protection element when the current in the protection element exceeds a threshold.

15. The electrical box according to any of claims 12-14, wherein the first power source and the second power source have the same voltage, and the third circuit further comprises a voltage converter configured to step up or step down the voltages of the first power source and the second power source such that the third circuit provides different magnitudes of voltages to the third group of electrical devices.
